## Europäisches Patentamt

## European Patent Office

## Office européen des brevets

(19)

(11) **EP 1 376 869 B1**

(12) **FASCICULE DE BREVET EUROPEEN**

(45) Date de publication et mention
de la délivrance du brevet:
**08.03.2006 Bulletin 2006/10**

(51) Int Cl.:
***H03K 5/13*** *(2006.01)*

(21) Numéro de dépôt: **03291443.4**

(22) Date de dépôt: **16.06.2003**

(54) **Circuit déphaseur variable, interpolateur de phase l'incorporant, et synthetiseur de fréquence numérique incorporant un tel interpolateur**

Variable Phasenverschiebungsschaltung, Phaseninterpolator mit einer solchen Phasenverschiebungsschaltung, und digitaler Frequenzsynthetisierer mit einem solchen Interpolator

Variable phase-shift circuit, phase interpolator including the same, and a digital frequency synthesizer incorporating such an interpolator

(84) Etats contractants désignés:
**DE FR GB IT**

(30) Priorité: **25.06.2002 FR 0207856**

(43) Date de publication de la demande:
**02.01.2004 Bulletin 2004/01**

(73) Titulaire: **STMicroelectronics S.A.**
**92120 Montrouge (FR)**

(72) Inventeurs:
• **Badets, Franck**
**38240 Meylan (FR)**

• **Belot, Didier**
**38140 Rives (FR)**

(74) Mandataire: **Verdure, Stéphane**
**Cabinet Plasseraud**
**65/67 rue de la Victoire**
**75440 Paris Cedex 09 (FR)**

(56) Documents cités:
**EP-A- 0 326 202**         **WO-A-00/65717**
**US-B1- 6 396 360**

**EP 1 376 869 B1**

**Description**

La présente invention concerne un circuit déphaseur variable, un interpolateur de phase l'incorporant, et un synthétiseur de fréquence numérique incorporant un tel interpolateur de phase.

Les interpolateurs de phase trouvent des applications, en particulier, dans le domaine de la synthèse de fréquence numérique puisqu'ils offrent une solution au problème de l'élimination des raies parasites (en anglais : "spurious") dans le spectre d'un signal synthétisé à l'aide d'un accumulateur de phase, notamment. Ces raies parasites proviennent de la périodicité de la gigue (en anglais : "jitter") qui affecte un tel signal de manière inhérente.

Une première architecture connue d'interpolateur de phase utilise un condensateur de valeur C déterminée, chargé par une source de courant délivrant un courant I déterminé, et un comparateur qui commute lorsque la tension aux bornes du condensateur excède une tension de seuil de valeur déterminée V. En faisant varier le courant de charge, ou la valeur du condensateur, ou encore la tension de seuil, il est possible de modifier l'instant t de commutation du comparateur. La relation liant ces quatre grandeurs étant : $t = \dfrac{I}{C \cdot V}$. Dans l'article "A Low-Power Direct Digital Synthesizer Using a Self-Adjusting Phase Interpolation Technique", H. Nosaka, Y. Yamaguchi, A. Yamagishi, H. Fukuyama and M. Muraguchi, IEEE Journal of Solid State Circuits, Vol. 36, No 8, Août 2001, le réglage de l'instant de commutation est ainsi réalisé en mettant en parallèle un nombre variable de sources de courant élémentaires.

Une deuxième architecture connue, appelée « Anti-Jitter Circuit » met en oeuvre un premier générateur d'impulsion de largeur fixe commandé par le signal issu de l'accumulateur de phase, une pompe de charge qui charge et décharge un condensateur, un comparateur, et un second générateur d'impulsion commandé sur les fronts descendants du comparateur. La durée de l'impulsion commandée par le signal issu de l'accumulateur de phase étant fixe, les instants d'apparition de l'impulsion de sortie sont équidistants, même si les fronts à son entrée ne le sont pas. La période ainsi obtenue correspond à la période moyenne du signal issu de l'accumulateur de phase.

Une troisième architecture connue consiste à utiliser un générateur d'horloge disposant de N phases, où N est un nombre entier, à la fréquence moyenne Fout du bit de débordement de l'accumulateur de phase. A chaque débordement de l'accumulateur de phase, on choisit celle des N phases qui permet de se rapprocher au plus près de la période moyenne 1/Fout du bit de débordement de l'accumulateur. Un exemple d'une telle architecture est donné dans l'article "A Virtual Clock Enhancement Method for DDS Using an Analog Delay Line", R. Richter, H.J. Jentschel, IEEE Journal of Solid State Circuits, Vol. 36, No 7, juillet 2001. Le générateur comprend une boucle d'éléments retardateurs, appelée boucle à verrouillage de délai ou DLL (de l'anglais "Delay Locked Loop"). Chaque élément retardateur est constitué par un inverseur.

L'efficacité de cette troisième architecture dépend du nombre de phases du générateur d'horloge. Pour atteindre une réjection satisfaisante des raies parasites, un nombre important de phases est requis. Néanmoins, le nombre d'inverseurs est limité en pratique, car, si on note D le retard introduit par chaque inverseur, il faut respecter la contrainte suivante :

$$N.D = Fclk \qquad\qquad\qquad (1)$$

où Fclk désigne la fréquence du signal d'horloge qui cadence l'accumulateur de phase.

Le document US-B1-6 396 360 divulgue en outre un oscillateur commandé en tension (VCO) comprenant deux circuits déphaseurs et un interpolateur. Les sorties des circuits déphaseurs sont couplées en entrée de l'interpolateur et la sortie de l'interpolateur est bouclée en entrée des circuits déphaseurs. La fréquence de résonance de l'interpolateur est située entre les fréquences de résonance respectives des circuits déphaseurs. Les signaux provenant des circuits déphaseurs sont sélectivement combinés par l'interpolateur selon un signal de commande. Ainsi, le VCO peut être accordé vers la fréquence de résonance de l'interpolateur.

L'invention vise à proposer une alternative à cet état de la technique, en proposant un circuit déphaseur variable offrant des caractéristiques adaptées à son utilisation dans un interpolateur de phase reposant sur une technique du type de la troisième architecture précitée. Néanmoins, les applications du circuit déphaseur de l'invention ne se limitent pas au cas des interpolateurs de phase, et dépassent largement le domaine de la synthèse de fréquence. En effet, ce circuit déphaseur peut trouver des applications dans bien d'autres domaines de l'électronique.

Un premier aspect de l'invention concerne ainsi un circuit déphaseur variable selon la revendication 1.

Un avantage d'un tel circuit est que le déphasage qu'il introduit peut être aussi petit que cela est requis. En outre, le fait que l'on puisse faire varier le déphasage et que cette variation puisse être aussi petite que requis permet de « simuler » la présence d'un grand nombre d'éléments de retard à partir d'un petit nombre de ces nouveaux circuits déphaseurs variables.

Un autre avantage provient de la rapidité d'acquisition de la phase en cas de modification du signal de commande, rendant ainsi de tels circuits déphaseurs variables de bons candidats pour des interpolateurs de phase.

Un deuxième aspect de l'invention concerne un interpolateur de phase selon la revendication 4.

Grâce à la structure des circuits déphaseurs variables, il est possible d'obtenir un pas d'interpolation très fin à partir d'un petit nombre N1 de circuits déphaseurs variables. Ceci se traduit par une bonne précision de l'interpolation.

Avantageusement, l'interpolateur peut comprendre en outre un convertisseur numérique/analogique ayant N1 entrées qui reçoivent les P-Q bits de poids le plus faible de ladite valeur numérique d'entrée, et ayant une sortie qui délivre, en fonction de la valeur desdits P-Q bits, un signal analogique de correction de déphasage qui est délivré sur l'entrée de commande de l'un au moins des N1 premiers circuits déphaseurs variable.

Ce signal de correction permet de modifier le déphasage introduit par le circuit déphaseur dont la sortie est sélectionnée par le multiplexeur pour délivrer le signal de sortie de l'interpolateur. Ainsi, on peut interpoler avec précision des valeurs de phases qui sont comprises entre les N1 valeurs de phases respectivement générées par les N1 circuits déphaseurs variables précités. Les performances de l'interpolation de phase sont encore améliorées, sans accroître le nombre de circuits déphaseurs utilisés.

Un troisième aspect de l'invention concerne un synthétiseur de fréquence numérique selon la revendication 14.

D'autres caractéristiques et avantages de l'invention apparaîtront encore à la lecture de la description qui va suivre. Celle-ci est purement illustrative et doit être lue en regard des dessins annexés sur lesquels :

- la figure 1 est un schéma symbolique d'un oscillateur synchronisé selon l'art antérieur ;
- la figure 2 est un graphe illustrant l'évolution de la fréquence du signal de sortie par rapport à la fréquence du signal d'entrée d'un oscillateur synchronisé ;
- la figure 3 est un graphe montrant le déphasage du signal de sortie par rapport au signal d'entrée d'un oscillateur synchronisé, en fonction de la différence entre la fréquence de synchronisation et la fréquence d'oscillation libre de l'oscillateur ;
- la figure 4 est un schéma symbolique d'un circuit déphaseur variable selon l'invention ;
- la figure 5 est un schéma détaillé d'un mode de réalisation d'un circuit déphaseur variable selon l'invention ;
- la figure 6 est un graphe montrant le déphasage du signal de sortie par rapport au signal d'entrée du circuit déphaseur variable de la figure 5 ;
- la figure 7 est un chronogramme d'un signal affecté d'une gigue (signal à interpoler) ;
- la figure 8 est un schéma d'un mode de réalisation d'un interpolateur de phase selon l'invention ;
- la figure 9 est un graphe illustrant la caractéristique d'un convertisseur numérique/analogique ;
- la figure 10 est un diagramme illustrant le positionnement en phase de huit circuits déphaseurs variables utilisés dans un interpolateur de phase selon la figure 8 ;
- la figue 11 est un chronogramme du signal en sortie de l'interpolateur de phase de la figure 8;
- la figure 12 est un schéma détaillé d'un exemple de transconductance utilisée dans un interpolateur de phase selon la figure 8 ;
- la figure 13 est une représentation schématique d'un premier exemple de synthétiseur de fréquence numérique selon l'invention
- la figure 14 est une représentation schématique d'un deuxième exemple de synthétiseur de fréquence numérique selon l'invention; et,
- la figure 15 est une représentation schématique d'un troisième exemple de synthétiseur de fréquence numérique selon l'invention.

Un oscillateur est un circuit qui comprend des moyens auto-oscillants et une sortie pour générer un signal oscillant. Un oscillateur est caractérisé par une fréquence libre, notée Fo dans la suite, qui est normalement la fréquence du signal de sortie.

Tous les oscillateurs ont néanmoins la propriété de recopier la fréquence d'un signal perturbateur si celle-ci est voisine de la fréquence d'oscillation libre Fo de l'oscillateur. Tous les oscillateurs sont ainsi caractérisés par une plage de synchronisation, dont la largeur dépend de l'amplitude du signal perturbateur et de la topologie de l'oscillateur. Connaissant l'amplitude du signal perturbateur (appelé signal de synchronisation), il est possible de calculer la plage de synchronisation ΔF de l'oscillateur à partir du calcul des facteurs d'élasticité de l'oscillateur. L'étude des oscillateurs synchronisés est décrite dans « Contribution à l'étude de la synchronisation des oscillateurs : intégration des oscillateurs synchrones dans les systèmes radiofréquences en technologie silicium », Chapitre 3, F. Badets, Thèse présentée à l'Université Bordeaux 1 le 25 janvier 2000, No d'ordre 2199.

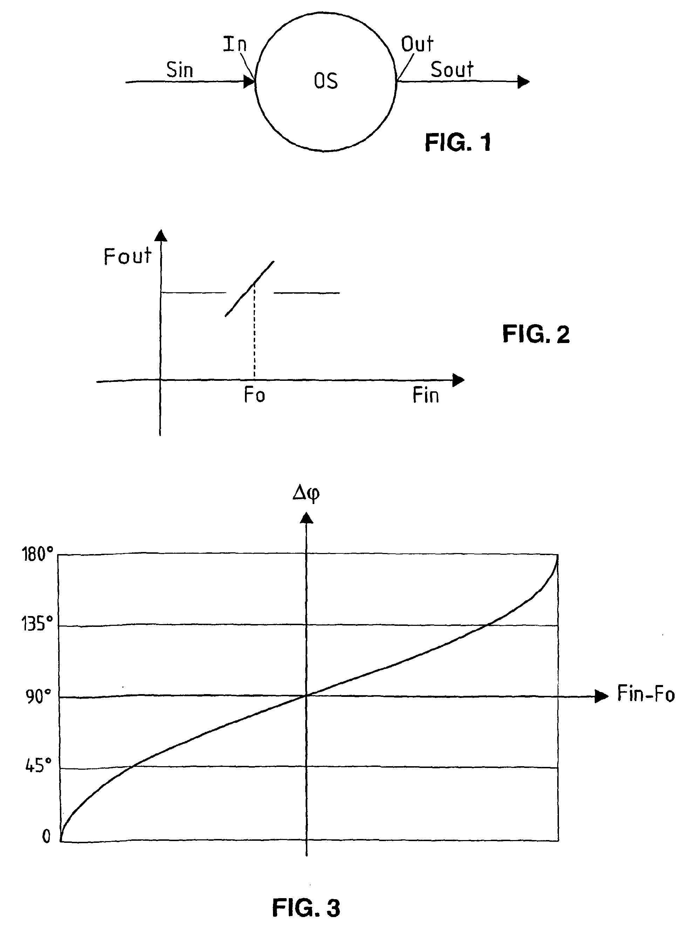

A la figure 1, on a représenté schématiquement un oscillateur synchronisé OS. Celui-ci comprend une entrée In pour recevoir un signal de synchronisation Sin, et une sortie Out pour délivrer un signal de sortie Sout. On note Fo la fréquence libre de l'oscillateur, Fin la fréquence du signal de synchronisation, et Fout la fréquence du signal de sortie.

L'évolution de la fréquence Fout en fonction de la fréquence Fin est illustrée par le graphe de la figure 2. Ainsi qu'on peut le voir sur ce graphe, la fréquence Fout est égale à la fréquence Fo pour les valeurs de Fin situées en dehors de la plage de synchronisation $\Delta F$, celle-ci étant centrée sur la valeur Fo. Pour les valeurs de Fin situées à l'intérieur de la plage de synchronisation $\Delta F$, la valeur de Fout est égale à Fin. Dit autrement, la pente de la courbe de la fonction donnant Fout en fonction de Fin est égale à l'unité dans la plage de synchronisation $\Delta F$, et elle est nulle en dehors de cette plage.

Lorsque l'oscillateur est synchronisé, la différence de phase $\Delta\varphi$ entre le signal de synchronisation Sin et le signal sortie de l'oscillateur Sout n'est fonction que de Fin, Fo et $\Delta F$. Cette relation est une loi en « Arcsin », comme le montre graphe de la figure 3. Lorsque Fin est égale à Fo, le déphasage $\Delta\varphi$ est égal à 90° (modulo 180°). La variation du déphasage $\Delta\varphi$ est sensiblement linéaire entre 45° et 135° (modulo 180°).

Dans les applications classiques des oscillateurs synchronisés, la grandeur d'entrée est la fréquence du signal de synchronisation Sin. Selon l'invention, on laisse cette grandeur fixe et on fait varier la fréquence d'oscillation libre Fo de l'oscillateur à la manière d'un oscillateur commandé. Bien entendu, pour que l'oscillateur reste synchronisé, la variation de la fréquence Fo est limitée afin que la fréquence Fin reste dans la plage de synchronisation $\Delta F$ résultante de l'oscillateur. Ainsi, la fréquence Fout est égale à Fin. Dans la suite, les termes « oscillateur synchronisé » se rapportent à un oscillateur qui satisfait cette condition. Ainsi, le déphasage $\Delta\varphi$ du signal en sortie de l'oscillateur par rapport au signal de synchronisation est commandé. Dit autrement, on obtient un circuit déphaseur variable comprenant un oscillateur synchronisé ainsi qu'une entrée de commande recevant un signal de commande qui a pour fonction de faire varier le déphasage $\Delta\varphi$ entre le signal de sortie et le signal d'entrée de l'oscillateur synchronisé en faisant varier la fréquence d'oscillation libre Fo de cet oscillateur.

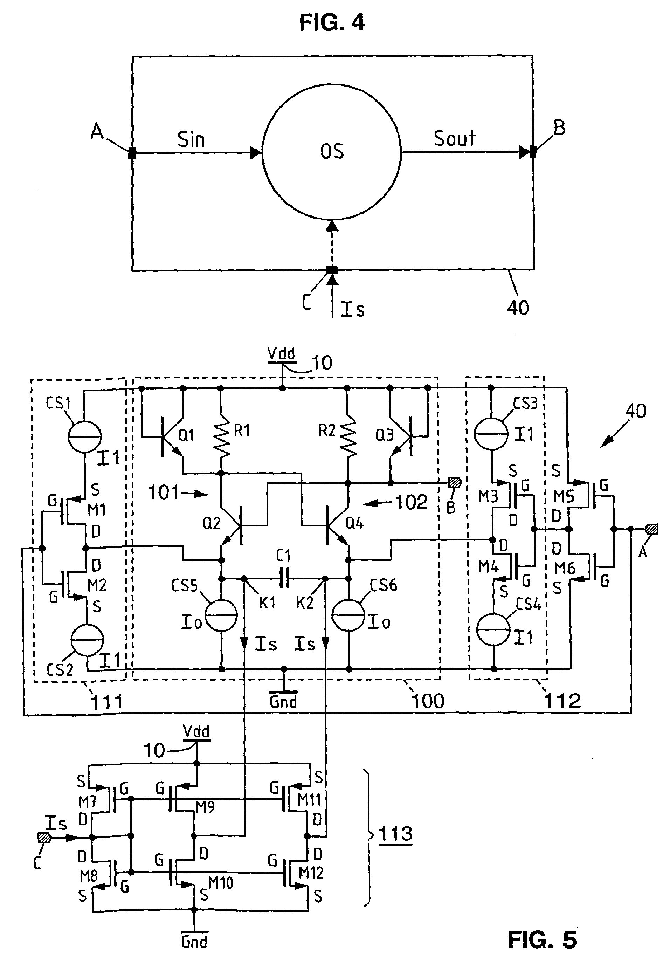

La figure 4 donne une représentation schématique d'un circuit déphaseur variable 40 selon l'invention. Le circuit 40 comprend une entrée A pour recevoir un signal d'entrée, une sortie B pour délivrer un signal de sortie, et une entrée de commande C pour recevoir un signal Is de commande de déphasage. Le signal is commande le déphasage $\Delta\varphi$ dudit signal de sortie par rapport audit signal d'entrée. De préférence, il s'agit d'une grandeur analogique. Plus particulièrement il s'agit d'un courant de commande, bien qu'une tension de commande soit également envisageable.

A la figure 5, on a représenté un mode de réalisation proposé pour le circuit déphaseur variable 40 selon l'invention.

Le circuit 40 comprend un oscillateur qui génère un signal oscillant ayant une fréquence d'oscillation libre déterminée Fo, ainsi que des moyens de synchronisation pour recevoir un signal de synchronisation ayant une fréquence déterminée comprise à l'intérieur de la plage de synchronisation $\Delta F$ de l'oscillateur, qui est déterminée notamment par la fréquence d'oscillation libre Fo.

Dans l'exemple, l'oscillateur comprend un circuit multivibrateur astable 100 comprenant deux branches 101 et 102 disposées en parallèle, chacune entre une borne d'alimentation positive 10 recevant une tension d'alimentation positive Vdd, et une borne d'alimentation négative ou la masse Gnd.

La première branche 101 du circuit 100 comprend, en série entre la borne 10 et la masse Gnd, un transistor bipolaire Q1 monté en diode (c'est-à-dire dont la base est reliée au collecteur), un transistor bipolaire Q2, et une source de courant CS5. Le collecteur et la base du transistor Q1 sont reliés ensemble et à la borne 10. L'émetteur du transistor Q1 est relié au collecteur du transistor Q2. L'émetteur du transistor Q2 est en outre relié à la masse Gnd à travers la source de courant CS5.

La seconde branche 102 du circuit 100 comprend, en série entre la borne 10 et la masse Gnd, un transistor bipolaire Q3 monté en diode, un transistor bipolaire Q4, et une source de courant CS6. Le collecteur et la base du transistor Q3 sont reliés ensemble et à la borne 10. L'émetteur du transistor Q3 est relié au collecteur du transistor Q4. L'émetteur du transistor Q4 est en outre relié à la masse Gnd à travers la source de courant CS6. La sortie B du circuit déphaseur variable 40 est prélevée sur le collecteur du transistor Q4 de la branche 102 du circuit multivibrateur 100.

La branche 101 comprend en outre une résistance R1 connectée entre la borne 10 et le collecteur du transistor Q2. De même, la branche 102 comprend en outre une résistance R2 connectée entre la borne 10 et le collecteur du transistor Q4.

En outre, la base du transistor Q2 est reliée au collecteur du transistor Q4 (sortie B), et la base du transistor Q4 est reliée au collecteur du transistor Q2.

Enfin, le circuit 100 comprend un condensateur C1 relié entre les émetteurs respectifs des transistors Q2 et Q4. Dans un exemple, la valeur de la capacité du condensateur C1 est égale à 0,8 pF (pico-Farad).

Les sources de courant CS5 et CS6 délivrent un courant constant respectif, de même valeur déterminée notée lo. Dans un exemple, lo est égal à 250 $\mu$A (micro-ampères).

En outre, les moyens de synchronisation comprennent une branche 111 et une branche 112 disposées en parallèle avec les branches 101 et 102 du circuit 100 entre la borne 10 et la masse Gnd. La branche 111 comprend, en série entre la borne 10 et la masse, une source de courant CS1, un transistor M1 qui est un transistor MOS de type P (transistor PMOS), un transistor M2 qui est un transistor MOS de type N (transistor NMOS), et une source de courant CS2. Les grilles de commande G des transistors M1 et M2 sont reliées ensemble. De plus, les drains communs D des transistors M1 et M2 sont reliés à l'émetteur du transistor Q2 de la branche 101 du circuit 100.

La branche 112 comprend, en série entre la borne 10 et la masse, une source de courant CS3, un transistor M3 qui est un transistor PMOS, un transistor M4 qui est un transistor NMOS, et une source de courant CS4. Les grilles de commande G des transistors M3 et M4 sont reliées ensemble. De plus, les drains communs D des transistors M3 et M4 sont reliés à l'émetteur du transistor Q4 de la branche 102.

Les sources de courant CS1, CS2, CS3 et CS4 délivrent un courant respectif ayant une même valeur 11. Dans un exemple, 11 est égal à 100 μA.

L'entrée A du circuit déphaseur variable est reliée aux grilles communes G des transistors M1 et M2 de la branche 111. Egalement, elle est reliée aux grilles communes G des transistors M3 et M4 de la branche 112 à travers un inverseur M5-M6.

L'inverseur M5-M6 comprend un transistor M5 qui est un transistor PMOS et un transistor M6 qui est un transistor NMOS, reliés en série entre la borne 10 et la masse Gnd. Les grilles de commande G des transistors M5 et M6 sont reliées ensemble et à l'entrée A. Les drains communs D des transistors M5 et M6 sont reliés aux grilles communes G des transistors M3 et M4 de la branche 112.

En fonctionnement, l'entrée A reçoit un signal d'entrée, qui correspond au signal de synchronisation Sin présenté plus haut, et qui possède une fréquence d'oscillation Fin déterminée.

Dans un exemple de réalisation préféré, le signal de commande Is reçu sur l'entrée de commande C est un courant de commande. En effet, plusieurs signaux de commande de cette nature peuvent alors être appliqués sur l'entrée C par liaison directe, permettant d'obtenir l'addition des effets respectifs de chacun de ces signaux sur le déphasage Δφ.

Selon l'invention, le circuit déphaseur variable comprend des moyens pour faire circuler dans les branches 101 et 102 du circuit 100 un courant de repos respectif, de même valeur Io+ls. Dit autrement, ce courant de repos comprend une partie fixe lo qui est délivrée par la source de courant respectivement CS5 et CS6, et une partie variable correspondant au courant de commande du déphasage Is. Dans le cas général, on dit que le courant Is s'ajoute au courant lo. Il s'agit d'une somme algébrique, le courant Is pouvant être positif ou négatif.

Dans chaque branche 101 ou 102, le courant Is est prélevé ou injecté sur un noeud respectivement K1 ou K2 correspondant au noeud commun à l'émetteur du transistor bipolaire, respectivement Q2 ou Q4, et à la borne positive de la source de courant, respectivement CS5 ou CS6.

A cet effet, le circuit déphaseur variable conforme au mode de réalisation de la figure 5 comprend un miroir de courant 113. Le miroir de courant 113 comprend trois branches reliées en parallèle entre la borne 10 et la masse Gnd. La première branche comprend un premier transistor M7 et un second transistors M8, qui sont des transistors MOS montés en diode, reliés en série entre la borne 10 et la masse Gnd par leurs drains D respectifs. Les deuxième et troisième branches comprennent chacune un premier transistor MOS, respectivement M9 et M11, et un second transistor MOS, respectivement M10 et M12, en série entre la borne 10 et la masse Gnd. Les transistors M7, M9 et M11 sont des transistors PMOS dont la source S est reliée à la borne 10. Leurs grilles respectives G sont reliées ensemble. Les transistors M8, M10 et M12 sont des transistors NMOS dont la source est reliée à la masse Gnd. Leurs grilles respectives G sont reliées ensemble et aux grilles de commande G des transistors M7, M9 et M11.

Les grilles communes G des six transistors M7-M12 sont reliées à l'entrée C du circuit déphaseur variable 40, qui reçoit le signal de commande Is (qui est un courant de commande Is dans l'exemple). Les drains D des transistors M9 et M10 de la deuxième branche sont reliés ensemble au noeud K1 de la première branche 101 du circuit 100. De même, les drains D des transistors M11 et M12 de la troisième branche sont reliés ensemble au noeud K2 de la seconde branche 102 du circuit 100.

Ainsi, le courant de commande Is reçu sur l'entrée C est dupliqué par le miroir de courant 113 afin de générer deux courants ls de même valeur qui sont prélevés ou injectés sur les noeuds respectivement K1 et K2.

Dans une variante, le circuit déphaseur variable 40 comprend deux entrées de commande telles que l'entrée C, chacune pour recevoir un signal de commande ls identique. Dans ce cas, ces deux entrées sont reliées aux noeuds respectivement K1 et K2, et le miroir de courant 113 peut être omis. Ce qui revient à dire que le miroir de courant 113 peut être compris dans l'élé ment qui génère le signal de commande Is au lieu d'être compris dans le circuit déphaseur variable 40. Il peut aussi être compris dans un élément situé entre ledit élément et le circuit 40.

La fréquence d'oscillation libre Fo du multivibrateur astable 100 est donnée par la relation suivante :

$$Fo = \frac{Io + Is}{4 \times Vbe \times C1} \qquad (2)$$

où C1 désigne la valeur de la capacité du condensateur C1,
et où Vbe désigne la tension base-émetteur des transistors Q1 et Q3.

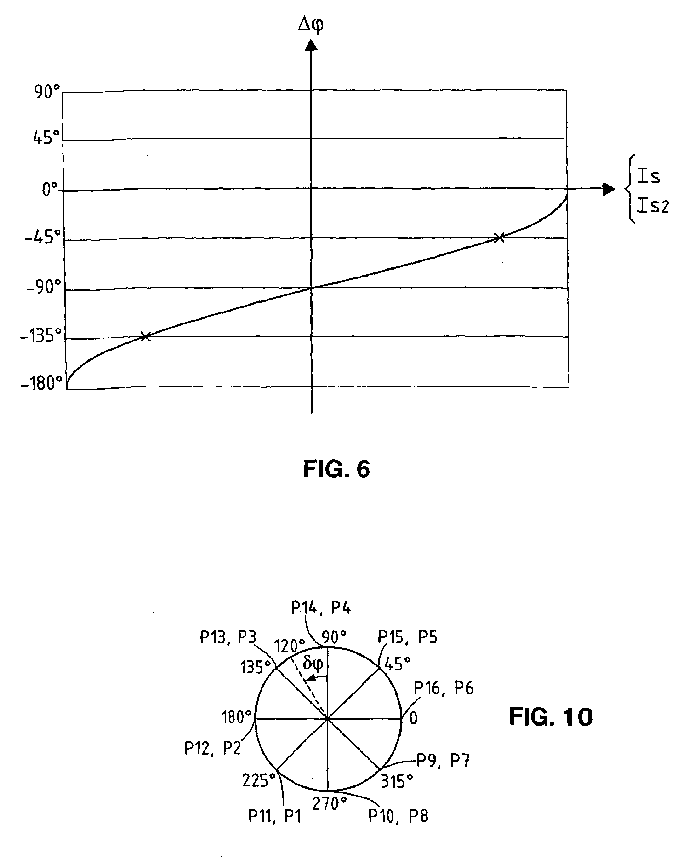

A la figure 6, on a représenté le graphe du déphasage $\Delta\varphi$ du signal délivré par la sortie B par rapport au signal reçu sur l'entrée A en fonction du signal de commande de déphasage Is reçu sur l'entrée C, du circuit déphaseur variable 40 de la figure 5.

Ce graphe a l'allure générale (fonction "Arcsin") déjà illustrée par le graphe de la figure 3. Néanmoins, compte tenu de la structure du circuit de la figure 5, le déphasage $\Delta\varphi$ est égal à -90° pour la valeur nulle du courant de commande de déphasage Is. Le déphasage varie linéairement lorsque le courant de commande Is varie entre deux valeurs déterminées qui donnent un déphasage $\Delta\varphi$ égal à, respectivement, -135° et -45°.

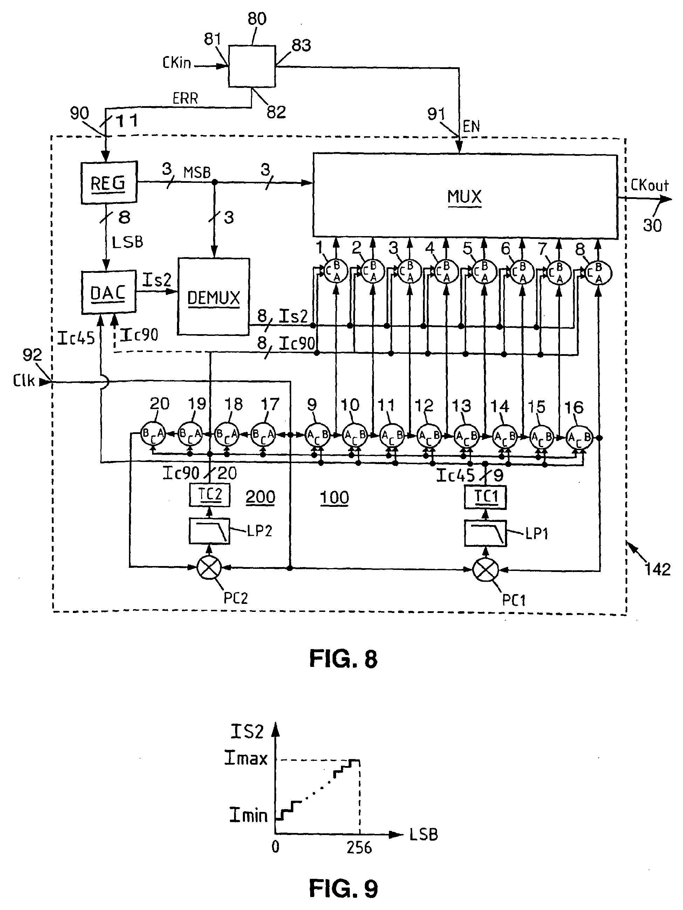

La figure 7 est un chronogramme d'un signal CKin affecté d'une gigue, qui dans l'exemple est un signal périodique (bien que l'invention ne se limite pas au cas d'un signal à interpoler qui soit périodique). Par signal périodique affecté d'une gigue, on entend un signal numérique comprenant une impulsion récurrente dont la position fluctue dans le temps, en ayant une période moyenne TCKin correspondant à r fois une période théorique Tck, où r est un nombre réel. Dit autrement, le signal possède des impulsions récurrentes qui ne sont périodiques qu'en moyenne sur plusieurs impulsions. Dans l'exemple représenté, r est égal à 8/3 ( $TCKin = \dfrac{8}{3} \times Tck$ ).

Si l'on considère des instants de commutation effectifs des impulsions du signal (correspondant par exemple aux fronts descendants des impulsions) par rapport à des instants de commutation théoriques, déterminés par un signal de référence ayant la fréquence 1/Tck, l'instant de commutation de certaines au moins des impulsions du signal CKin représenté est en retard ou en avance par rapport à un instant de commutation théorique associé.

Dans l'exemple représenté, la première impulsion (la plus à gauche) a un instant de commutation correspondant à un instant de commutation théorique. Dit autrement, l'impulsion est en phase avec le signal de référence ayant la fréquence 1/Tck. La deuxième impulsion est en retard d'un tiers de la période Tck par rapport à un instant de commutation théorique, c'est-à-dire que le signal CKin est ponctuellement déphasé de 360°/3=120° par rapport au signal de référence ayant la fréquence 1/Tck. La troisième impulsion est en retard de deux tiers de la période Tck par rapport à un instant de commutation théorique, c'est-à-dire que le signal CKin est ponctuellement déphasé de 360°x 2/3=240° par rapport au signal de référence ayant la fréquence 1/Tck. La quatrième impulsion est à nouveau en phase avec le signal de référence, etc. On notera que ceci est un exemple particulièrement simple. Dans le cas général, le retard (ou l'avance) de l'instant de commutation effectif d'une impulsion par rapport à un instant de commutation théorique n'est pas nécessairement égal à une fraction entière de la période théorique Tck.

Un signal tel que le signal CKin représenté à la figure 7 est par exemple généré par un accumulateur de phase comprenant un additionneur 3 bits, activé par un signal d'horloge déterminé avec un incrément d'addition égal à 3. Le signal de référence ayant la fréquence 1/Tck correspond alors audit signal d'horloge. D'une façon générale, l'invention s'applique à l'mterpolation de phase d'un signal affecté d'une gigue qui peut être produit par un circuit numérique synchrone quelconque (accumulateur de phase ou autre), celui-ci pouvant être cadencé par un signal d'horloge ayant une fréquence déterminée.

Lorsque le signal affecté d'une gigue est un signal destiné à être émis dans le spectre radiofréquence, la périodicité de la gigue se traduit par des raies parasites dans le spectre du signal émis. La gigue est classiquement éliminée grâce à un circuit d'interpolation de phase, ou interpolateur de phase. C'est pourquoi, dans la suite, ce signal est aussi appelé signal à interpoler.

La figure 8 représente de façon schématique un exemple de réalisation d'un interpolateur de phase 142 selon l'invention. Pour des raisons de clarté, les connexions comprenant un nombre n déterminé de fils, où n est un nombre entier supérieur à l'unité, sont indiquées à la figure par un trait unique. En tant que de besoin, l'indication "/n" est alors indiquée en travers de ce trait unique.

L'interpolateur de phase 142 comprend une sortie 30 pour délivrer un signal de sortie CKout, aussi appelé signal interpolé dans la suite.

On suppose qu'un module de commande 80 comprend une entrée 81 pour recevoir un signal d'entrée CKin, qui est un signal, périodique ou non, affecté d'une gigue. Le module 80 comprend également une sortie 82 qui délivre des valeurs numériques ERR successives, sur lesquelles on reviendra ci-dessous. Il comprend aussi une sortie 83 qui délivre un signal d'activation EN (qui est un signal binaire) sur lequel, également, on reviendra plus loin.

Le module 80 peut être réparti dans plusieurs entités, en fonction de l'application. En variante, il peut-être compris dans l'interpolateur de phase 142 lui-même.

L'interpolateur 142 comprend une entrée de signal 92 pour recevoir un signal de référence ayant une fréquence déterminée, qui est par exemple un signal d'horloge Clk. Le signal Clk est par exemple le signal d'horloge qui cadence le circuit numérique générant le signal CKin

De plus, l'interpolateur 142 comprend au moins une entrée de données 90 pour recevoir une valeur numérique d'entrée ERR codée sur P bits, où P est un nombre entier supérieur à l'unité. Dans un exemple P est égal à onze (P=11). Les valeurs numériques d'entrée ERR représentent l'écart temporel entre un instant de commutation effectif d'une impulsion du signal à interpoler CKin et un instant de commutation désiré du signal de sortie CKout, qui est par exemple déterminé par une période moyenne du signal à interpoler (notamment lorsque le signal CKin est généré par un accumulateur de phase).Dit autrement, elles représentent le déphasage ponctuel du signal CKin par rapport à sa fréquence moyenne 1/TCKin. Dans cet exemple, les valeurs numériques d'entrée sont successivement reçues à une fréquence sensiblement égale à 1/TCKin. Elles sont stockées dans un registre REG.

On note MSB les Q bits de poids le plus fort de la valeur numérique d'entrée, où Q est un nombre entier strictement inférieur à P. Dans un exemple, Q est égal à trois (Q=3). De même on note LSB les P-Q bits de poids le plus faible de ladite valeur numérique d'entrée. Dans l'exemple, P-Q est égal à huit (P-Q=8). Les bits MSB codent une valeur grossière de l'écart temporel précité, et les bits LSB codent une valeur supplémentaire qui précise la valeur de cet écart.

En variante, l'interpolateur 142 comprend deux entrées au lieu de l'entrée 90, l'une recevant les P bits MSB et l'autre recevant les P-Q bits LSB. Le registre REG peut alors être omis.

L'interpolateur 142 comprend en outre N1 premiers circuits déphaseurs variables, où N1 est un nombre entier strictement supérieur à l'unité. Dans un exemple, N1 est égal à huit (N1=8). Ces huit circuits déphaseurs variables 1 à 8 sont identiques. Ils sont par exemple conformes à l'exemple de réalisation décrit plus haut en regard de la figure 5. Chacun d'eux comprend un oscillateur synchronisé, une entrée A qui reçoit un signal d'entrée ayant la fréquence 1/Tck du signal de référence Clk comme signal de synchronisation de l'oscillateur, une entrée de commande C, et une sortie B qui délivre le signal de sortie de l'oscillateur. Ce dernier correspond au signal reçu sur l'entrée A déphasé en fonction d'un signal de commande qui est reçu sur l'entrée de commande C. Les signaux d'entrée reçus par les entrées A respectives de ces N1 circuits déphaseurs variables ont la fréquence 1/Tck du signal de référence Clk. De plus, ils sont déphasés deux à deux de 360°/N1, c'est-à-dire de 45° dans l'exemple où N1=8.

L'interpolateur 142 comprend en outre un multiplexeur MUX ayant N1 entrées reliées aux sorties respectives B des N1 circuits déphaseurs variables 1 à 8, une sortie qui est reliée à une sortie 30 de l'interpolateur pour délivrer un signal de sortie CKout, ainsi qu'au moins Q entrées de commande qui reçoivent les Q bits MSB. Le multiplexeur est activé par le signal EN délivré par la sortie 83 du module de commande 80 et reçu sur une entrée 91 de l'interpolateur 142. Ce multiplexeur MUX a pour fonction de sélectionner, lorsqu'il est activé par le signal EN (par exemple lorsque EN est à l'état logique haut), l'un des N1 signaux délivrés par les sorties B respectives des N1 circuits 1 à 8, en fonction de la valeur desdits Q bits MSB. Le signal ainsi sélectionné est délivré sur la sortie 30 de l'interpolateur. Le signal EN permet d'activer/désactiver le multiplexeur MUX afin de modifier la fréquence du signal de sortie CKout par rapport à la fréquence du signal de référence Clk.

De préférence, l'interpolateur 142 comprend encore un convertisseur numérique/analogique DAC (ici un convertisseur 8 bits) ayant P-Q entrées qui reçoivent respectivement les P-Q bits LSB, et ayant une sortie qui délivre un signal analogique de correction de déphasage ls2 en fonction de la valeur desdits P-Q bits. Ce signal de correction de déphasage ls2 permet d'améliorer l'interpolation de phase, puisqu'il permet de donner au signal en sortie du circuit déphaseur variable dont la sortie est sélectionnée par le multiplexeur, la valeur de phase réellement requise. Dit autrement, la sortie de l'un des circuits 1 à 8 est sélectionnée en fonction de la valeur grossière du déphasage du signal CKin (donnée par les bits MSB) et le déphasage introduit par ce circuit est ajusté par le signal de correction ls2 en fonction de la différence (donnée par les bits LSB) entre cette valeur grossière et la valeur réelle du déphasage du signal CKin (donnée par les P bits de la valeur numérique d'entrée).

Le signal de correction de déphasage ls2 peut être délivré sur l'entrée de commande C de chacun des N1 circuits déphaseurs variables 1 à 8. En effet, la sortie de l'un seulement de ces circuits est sélectionnée par le multiplexeur MUX pour produire le signal de sortie CKout. Toutefois, afin d'augmenter la rapidité d'acquisition de la phase en cas de modification du signal de commande, il est préférable de laisser les autres circuits déphaseurs avec la valeur du déphasage correspondant à un signal de correction de déphasage nul.

C'est pourquoi l'interpolateur 142 comprend de préférence un démultiplexeur DEMUX ayant une entrée qui reçoit le signal de correction de déphasage ls2, au moins N1 sorties qui sont respectivement couplées à l'entrée de commande C des N1 circuits déphaseurs variables 1 à 8, ainsi qu'au moins Q entrées de commande qui reçoivent les Q bits MSB. Ce démultiplexeur a pour fonction de sélectionner celles desdites N1 sorties qui est couplée à ladite entrée en fonction de la valeur des Q bits MSB. Dit autrement, il oriente le signal de commande de déphasage ls2 vers l'entrée de commande C de l'un seulement des circuits déphaseurs variables 1 à 8 en fonction de la valeur des Q bits MSB.

Pour générer les N1 signaux transmis en entrée des circuits déphaseurs variables 1 à 8, l'interpolateur de phase peut en outre comprendre un générateur d'horloge multiphase 100. Un tel générateur comprend de préférence N1 seconds circuits déphaseurs variables 9 à 16 identiques aux N1 premiers circuits déphaseurs variables 1 à 8. Les circuits 9 à 16 sont reliés en série via leurs entrées A et sorties B respectives. L'entrée d'un premier 9 de ces N1 seconds circuits déphaseurs variables reçoit le signal d'entrée CKin.

On pourrait bien entendu utiliser d'autres éléments déphaseurs au lieu et place des N1 seconds circuits déphaseurs variables, par exemple des inverseurs ou des éléments introduisant un retard quelconque. Néanmoins, on verra plus loin que l'exemple envisagé ici est avantageux car il permet de disposer d'une valeur de référence pour la calibration du convertisseur DAC.

Le générateur 100 comprend aussi un comparateur de phase PC1 ayant une première entrée qui reçoit le signal de référence Clk, une seconde entrée qui est reliée à la sortie d'un dernier 16 des N1 seconds circuits déphaseurs variables 9 à 16, ainsi qu'une sortie.

Le générateur 100 comprend aussi un filtre passe-bas LP1 ayant une entrée couplée à la sortie du comparateur de phase PC1, et ayant une sortie.

Il comprend enfin un module d'adaptation TC1 ayant une entrée couplée à la sortie du filtre passe-bas LP1 et au moins une sortie délivrant un signal de calibration lc45 à appliquer sur les entrées de commande C respectives des circuits 9 à 16. Lorsque les entrées de commande C des circuits 9 à 16 sont adaptées pour recevoir un courant de commande, comme c'est le cas dans l'exemple de réalisation préféré, le module TC1 est une transconductance. Le module TC1 comprend alors au moins N1 premières sorties délivrant respectivement N1 signaux analogiques de calibration Ic45 identiques. Ces sorties sont couplées aux entrées de commande C respectives des N1 seconds circuits déphaseurs variables 9 à 16, pour délivrer l'un des signaux lc45.

Dit autrement, le générateur 100 est une boucle à verrouillage de délai (DLL), dont les éléments retardateurs sont des circuits déphaseurs variables selon le premier aspect de l'invention.

Le convertisseur DAC doit être calibré de manière à commander les valeurs lmin et lmax du courant de correction de déphasage ls2 qu'il délivre, respectivement pour la valeur 0 et pour la valeur 256 déterminée par les huit bits LSB. Ces valeurs lmin et lmax déterminent les limites de la réponse du convertisseur DAC. Cette réponse est illustrée par le graphe de la figure 9 dans le cas d'un convertisseur ayant une caractéristique linéaire. On notera qu'un convertisseur numérique/analogique ayant une caractéristique linéaire est un cas préféré mais nullement limitatif. Une caractéristique non-linéaire peut être plus appropriée dans certaines applications de l'interpolateur, en fonction des propriétés de la gigue à corriger et/ou de la pente de la réponse des circuits déphaseurs variables utilisés.

La calibration du convertisseur DAC nécessite de connaître deux valeurs de référence, c'est-à-dire deux valeurs du courant de commande à appliquer sur l'entrée de commande C d'un circuit déphaseur variable tels que les circuits 1 à 8 utilisés, respectivement pour deux valeurs déterminées distinctes du déphasage $\Delta\varphi$. De préférence, ces deux valeurs du déphasage $\Delta\varphi$ correspondent directement aux valeurs lmin et lmax précitées du courant ls. Néanmoins, ceci n'est nullement obligatoire. En effet, les valeurs lmin et lmax peuvent être extrapolées à partir d'au moins deux valeurs de référence quelconques. De préférence également, les valeurs de référence appartiennent à une portion de la courbe de la réponse des circuits déphaseurs variables utilisés qui est linéaire. La conception de l'interpolateur est alors plus simple.

Avantageusement, le générateur du signal d'horloge multiphase 100, tel qu'il est réalisé selon l'exemple préféré décrit ci-dessus, fournit déjà une telle valeur de référence. En effet, on sait que le signal de calibration lc45 généré par la sortie du module d'adaptation TC1 du générateur 100 produit un déphasage $\Delta\varphi$ du signal en sortie B par rapport au signal sur l'entrée A des circuits 9 à 16 qui est égal à -45°. On dispose donc déjà d'une des deux valeurs de référence requises que l'on peut aisément utiliser.

A cet effet, le module d'adaptation TC1 du générateur d'horloge multiphase 100 comprend une N1 + 1-ième sortie, délivrant un N1 +1-ième signal de calibration lc45 identique aux N1 autres signaux de calibration Ic45 générés. Cette N1 + 1-ième sortie est couplée au convertisseur DAC afin de lui fournir une première valeur de référence pour sa calibration.

Dit autrement, le générateur 100 assure alors également la fonction de premiers moyens de calibration générant un premier signal de calibration lc45 pour la calibration du convertisseur DAC.

On notera que, lorsque le générateur de signal d'horloge multiphase 100 est réalisé autrement (par exemple grâce à une boucle à verrouillage de phase, ou par une DLL ayant des inverseurs comme circuits retardateurs), des moyens de calibration de même nature que le générateur 100 peuvent être prévus spécifiquement pour l'obtention du signal à calibration lc45 nécessaire à la calibration du convertisseur DAC.

Pour l'obtention d'une seconde valeur de référence pour la calibration du convertisseur DAC, l'interpolateur de phase selon l'invention peut en outre comprendre des seconds moyens de calibration 200 comprenant N2 troisièmes circuits déphaseurs variables, où N2 est un nombre entier. Par exemple, N2 est égal à quatre (N2=4). Ces quatre circuits déphaseurs variables 17 à 20 sont identiques aux N1 premiers circuits déphaseurs variables 1 à 8. Ils sont donc identiques, également, aux N1 deuxièmes circuits déphaseurs variables 9 à 16 du générateur 100. En outre, ils sont reliés en série via leurs entrées A et sorties B respectives, l'entrée d'un premier 17 de ces N2 troisièmes circuits déphaseurs variables recevant le signal de référence Clk.

Les seconds moyens de calibration 200 comprennent aussi un comparateur de phase PC2 ayant une première entrée qui reçoit le signal de référence Clk, une seconde entrée qui est reliée à la sortie d'un dernier 20 des N2 troisièmes circuits déphaseurs variables, ainsi qu'une sortie.

Ils comprennent aussi un filtre passe-bas LP2 ayant une entrée couplée à la sortie du comparateur de phase PC2, ainsi qu'une sortie.

Enfin, ils comprennent un module d'adaptation TC2, de même nature que le module TC1du générateur 100, ayant une entrée couplée à la sortie du filtre passe-bas LP2 et au moins une sortie délivrant un signal analogique de calibration lc9O à appliquer sur les entrées de commande de déphasage C des circuits 17 à 20, et en outre à délivrer au convertisseur DAC pour sa calibration. Ces entrées C étant adaptées pour recevoir un signal de commande en courant, le module TC2 peut comprendre N2 + 1 sorties délivrant chacune un signal analogique de calibration identique lc90. N2 de ces entrées sont couplées aux entrées de commande C respectives des N2 seconds circuits déphaseurs variables 17 à 20 pour délivrer l'un respectif parmi N2 des N2+1 signaux lc90. La dernière sortie est couplée au convertisseur DAC pour délivrer le N2+1-ième des N2+1 signaux lc90 afin de lui fournir une seconde valeur de référence pour sa calibration (ce couplage étant représenté en traits discontinus à la figure 8, dans la mesure où il ne correspond pas au mode de réalisation préféré).

Dit autrement, les moyens de calibration 200 sont une boucle à verrouillage de délai (DLL), dont les éléments retardateurs sont des circuits déphaseurs variables selon le premier aspect de l'invention. Le signal de calibration Ic90 produit un déphasage de -90° lorsqu'il est appliqué sur l'entrée de commande C d'un tel circuit déphaseur variable.

Dans un mode de réalisation préféré de l'interpolateur de phase, le signal Ic90 n'est pas couplé au convertisseur DAC. Il est considéré qu'une seconde valeur de référence correspond à une valeur nulle du courant de correction de déphasage ls2 et à une valeur du déphasage Δφ égale à -90°. De cette façon, on peut utiliser un convertisseur numérique/analogique le plus simple possible, pour lequel la valeur nulle des bits LSB fournit une valeur nulle du signal de correction de déphasage ls2 c'est-à-dire que la réponse du convertisseur (figure 9) passe par l'origine (Imin=0).

Dans ce mode de réalisation préféré (qui correspond à celui représenté en traits continus à la figure 8), le module d'adaptation TC2 comprend alors N2 + 2xN1 sorties délivrant respectivement N2 + 2xN1 signaux de calibration Ic90 identiques, parmi lesquels :

- N2 signaux Ic90 sont appliqués sur les entrées de commande C respectives des N2 seconds circuits déphaseurs variables 17 à 20 ;

- N1 autres signaux Ic90 sont appliqués sur les entrées de commande C respectives des N1 deuxièmes circuits déphaseurs variables 9 à 16 du générateur d'horloge multiphase 100 ; et,

- N1 autres signaux lc9O sont appliqués sur les entrées de commande C respectives des N1 premiers circuits déphaseurs variables 1 à 8.

Dans l'exemple considéré dans la présente description, le nombre N2+2xN1 est égal à vingt (N2+2xN1=20). Le fait d'appliquer le signal de calibration lc90 sur l'entrée de commande C de chacun des circuits déphaseurs variables 1 à 20 permet de s'assurer que chacun de ces circuits (en l'absence, en outre, de signal de correction de phase ls2 pour les circuits 1 à 8), présente un déphasage Δφ qui est strictement égal à -90°, et ce en dépit des dispersions sur les valeurs du courant Io, du condensateur C1 et des tensions Vbe résultant du procédé de réalisation sur silicium et/ou des phénomènes liés à la température. C'est pourquoi, dans ce cas, le signal de calibration lc90 n'a pas besoin d'être fourni au convertisseur DAC. On est en effet assuré que, pour la valeur nulle du signal de correction de phase ls2, le déphasage Δφ des circuits 1 à 8 sera bien égal à -90°.

On notera que le signal lc90 s'ajoute au signal lc45 sur l'entrée de commande C des circuits 9 à 16 (pour ces circuits, Is=Ic90+Ic45), en sorte que leurs effets respectifs sur le déphasage Δφ de ces circuits s'additionnent. De même, le signal lc90 s'ajoute au signal de correction de déphasage ls2 sur l'entrée de commande C des circuits 1 à 8 (pour ces circuits, Is=Ic90+Is2), en sorte que leurs effets respectifs sur le déphasage Δφ de ces circuits s'additionnent.

La réponse des circuits déphaseurs variables 1 à 8 en fonction du signal de correction de déphasage ls2 est illustrée par le graphe de la figure 6, déjà analysée. Les circuits 1 à 8 sont utilisés dans la portion de leur caractéristique comprise entre des valeurs du déphasage Δφ égale à -90° et à -45°, respectivement pour une valeur des bits LSB égale à 0 et à 256.

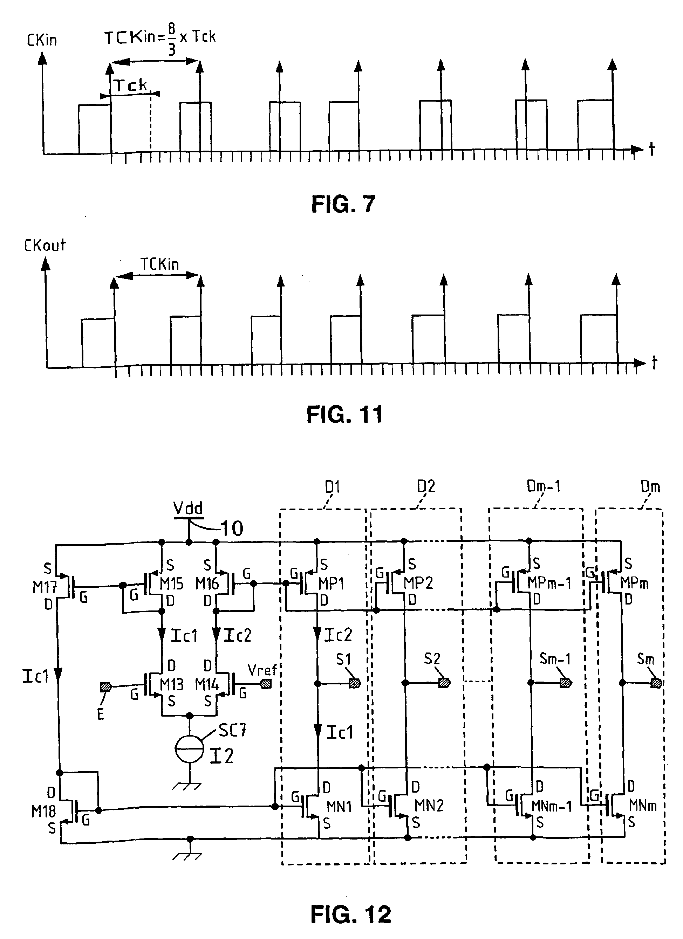

Le diagramme de la figure 10 illustre le déphasage, par rapport au signal de référence Clk, des signaux en sortie des circuits 1 à 8 en l'absence de signal de correction de déphasage ls2 (c'est-à-dire pour LSB=0 en sorte que le signal ls2 est nul), et en outre des signaux en sortie des circuits 9 à 16. Sur cette figure, on note P1 à P16 les phases des circuits 1 à 16, respectivement, par rapport à la phase du signal Clk prise pour référence. Par construction, chacun des circuits 1 à 16 introduit un déphasage de -90° entre son entrée A et sa sortie B. En outre, de par sa position dans la DLL du générateur 100, chacun des circuits 9 à 16 introduit un déphasage de +45° entre son entrée A et sa sortie B. Donc en réalité, chacun des circuits 9 à 16 introduit un déphasage de -90°+45° = -45° entre son entrée A et sa sortie B. Il en résulte que la phase P9 est égale à -45° (soit 315° modulo 360°), la phase P10 est égale à -90° (soit 270° modulo 360°), etc. De plus, il en résulte que la phase P1 est égale à -90° + 45° -90° = -235° (soit 225° modulo 360°), la phase P2 est égale à -180° (soit 180° modulo 360°), etc..

A titre d'exemple du fonctionnement de l'interpolateur 142, supposons que l'écart entre l'instant de commutation effectif d'une impulsion du signal à interpoler CKin et l'instant de commutation désiré du signal de sortie CKo ut, tel qu'il est indiqué par la valeur numérique d'entrée reçue sur l'entrée 80, et tel qu'il est déterminé par rapport à la période Tck du signal de référence Clk, corresponde à un déphasage ponctuel de 120° du signal CKin par rapport à la fréquence 1/Tck du signal de référence Clk. Les bits MSB ont alors une valeur qui fait que le multiplexeur MUX sélectionne le signal délivré par la sortie B du circuit déphaseur variable 4 dont le signal d'entrée présente un déphasage de 90° (soit -270° modulo 360°) par rapport au signal de référence Clk qui est le plus proche (par valeur inférieure) dudit déphasage ponctuel. En outre, les bits MSB font que le démultiplexeur DEMUX oriente le signal de correction de déphasage Is2 vers l'entrée de commande C du circuit 4. Enfin, les bits LSB ont une valeur qui fait que le signal de correction de déphasage ls2 généré par le convertisseur DAC ajoute un déphasage supplémentaire $\delta\varphi$ de 30° (représenté par une flèche à la figure 10) qui est le déphasage $\Delta\varphi$ du signal de sortie du circuit 4 par rapport au signal d'entrée de ce circuit.

En fait, le signal de correction ls2 retranche un déphasage de -30° puisqu'il fait que le circuit 4 introduit un déphasage de -60° au lieu d'un déphasage de -30°.

Le signal en sortie 142 de l'interpolateur est représenté par le chronogramme de la figure 11. Ainsi qu'on peut le voir, la gigue a été supprimée. Les impulsions ont un instant de commutation en phase avec l'instant de commutation désiré, qui est ici déterminé par la période Tck (flèches verticales).

La figure 12 fournit l'illustration d'un exemple de réalisation des modules d'adaptation TC1 et TC2.

Le module d'adaptation est une transconductance comprenant une entrée E et m sorties S1 à Sm, où m est un nombre entier. Par exemple, pour le module TC1 du générateur 100, le nombre m égal à 9. De même, pour le module TC2 des moyens de calibration 200, le nombre m est égal à 20.

Le module comprend une paire différentielle ayant un transistor MOS M13 et un transistor MOS M14 qui sont des transistors NMOS. La grille de commande G du transistor M13 est reliée à l'entrée E. La grille de commande G du transistor M14 reçoit une tension de référence Vref. Les sources S des transistors M13 et M14 sont reliées ensemble et à la masse à travers une source de courant SC7. La source de courant SC7 délivre un courant 12. Le drain D du transistor M13 est relié à la borne d'alimentation positive 10 à travers un transistor M15 monté en diode. De même, le drain D du transistor M14 est relié à la borne 10 à travers un transistor MOS monté en diode M16. Les transistors M15 et M16 sont des transistors PMOS, dont les sources S sont reliées à la borne 10, dont les drains D sont reliés aux drains D respectifs des transistors M13 et M14, et dont les grilles de commande G sont reliées à leur drain respectif D. Le transistor M15 est monté en miroir de courant avec un transistor M17 et un transistor M18. Les transistors M17 et M18 sont reliés en série entre la borne 10 et la masse Gnd. Le transistor M17 est un transistor PMOS dont la source S est reliée à la borne 10 et dont la grille G est reliée à la grille G du transistor M15. Le transistor M18 est un transistor NMOS dont la source S est reliée à la masse Gnd, dont le drain D est relié au drain D du transistor M17, et dont la grille de commande G est reliée à son drain D.

Le circuit d'adaptation comprend en outre m étages de sortie respectivement D1 à Dm. Chaque étage D1 à Dm comprend un premier transistor, respectivement MP1 à MPm, et un second transistor respectivement MN1 à MNm, reliés en série entre la borne 10 et la masse Gnd. Les transistors MP1 à MPm sont des transistors PMOS dont la source S est reliée à la borne 10, dont le drain D est relié à la sortie respectivement S1 à Sm du circuit d'adaptation. Les transistors MN1 à MNm sont des transistors NMOS dont la source S est reliée à la masse Gnd, dont le drain D est relié à la sortie respectivement S1 à Sm du circuit d'adaptation. En outre, les grilles de commande communes G des transistors MP1 à MPm sont reliées à la grille de commande du transistor M16. De plus, les grilles de commande communes G des transistors MN1 à MNm sont reliées à la grille de commande G du transistor M18.

Le fonctionnement de ce module d'adaptation est le suivant. L'entrée E reçoit le signal délivré par la sortie du filtre passe-bas LP1 (pour le module TC1) ou du filtre passe-bas LP2 (pour le module TC2). En fonction de la différence entre la tension correspondant à ce signal et la tension Vref, appliquées sur les grilles respectives des transistors M13 et M14 de la paire différentielle, des courants Ic1 et Ic2 s'établissent dans les deux branches de ladite paire différentielle, en respectant l'égalité Ic1+Ic2=12. Les transistors M15, M17, M18 et MN1 à MNm étant montés en miroir de courant, le courant Ic1 se retrouve sur les drains D des transistors MN1 à MNm. De même, les transistors M16 et MP1 à MPm étant montés en miroir de courant, le courant lc2 se retrouve sur les drains D des transistors MP1 à MPm. Par conséquent, les sorties S1 à Sm délivrent un courant qui correspond à la différence entre les courants Ic1 et lc2. Ce courant est un courant de commande qui correspond au courant de calibration lc45 pour le module Tc1 et au courant de calibration lc90 pour le module Tc2.

L'interpolateur de phase selon l'invention trouve des applications dans le domaine de la synthèse de fréquences numérique.

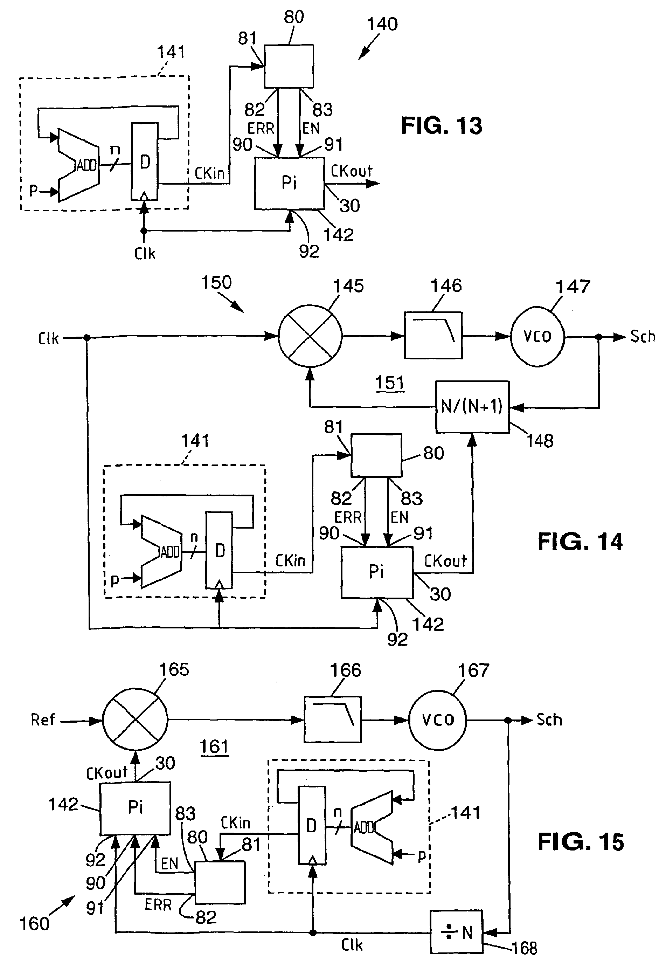

Le schéma de la figure 13 illustre un premier mode de réalisation d'un synthétiseur de fréquence numérique 140 comprenant un interpolateur de phase 142 selon le second aspect de l'invention et un circuit de commande 80 associé, par exemple tels que décrits ci-dessus en référence à l'exemple de réalisation montré à la figure 8.

Ce premier exemple de réalisation d'un synthétiseur correspond à un synthétiseur de fréquence direct «1bit». Il comprend un accumulateur de phase 141. Cet accumulateur de phase 141 comprend un additionneur ADD qui est un additionneur n bits, où n est un nombre entier, recevant sur une première entrée un incrément d'addition p, où p est un nombre entier. La valeur en sortie de l'additionneur ADD est stockée dans un registre R composé de bascules D (en anglais : "D latch") dont une sortie est bouclée sur une seconde entrée de l'additionneur ADD. Le registre R est activé par un signal d'horloge Clk.

Le fonctionnement de l'accumulateur est le suivant. A chaque front montant du signal d'horloge Clk, l'additionneur ADD s'incrémente d'une valeur p. Lorsque le résultat de l'addition est supérieur à la capacité de l'additionneur, qui est égale à $2^n$, un bit dit « bit de débordement » est généré sur une seconde sortie du registre R. Le résultat de cette addition (modulo $2^n$) sert alors de valeur de départ pour le cycle d'addition suivant. Le signal de sortie de l'accumulateur de phase 141 est généré par ladite seconde sortie du registre R, et est composé de la succession des impulsions correspondant aux occurrences du bit de débordement. Dans le cas où p et n sont égaux à 3, ce signal de sortie est le signal CKin illustré par le chronogramme de la figure 7. La fréquence Fin du signal CKin est donnée par la relation suivante :

$$Fin=(p/2^n)Fclk$$

où Fclk est la fréquence du signal d'horloge Clk. Ainsi qu'il a déjà été dit, ce signal est affecté d'une gigue, qui peut être éliminée grâce à un interpolateur de phase.

Selon l'invention, le synthétiseur 140 comprend ainsi un interpolateur de phase 142 qui génère, à partir du signal CKin précité, un signal de sortie CKout qui est par exemple le signal CKout illustré par le chronogramme de la figure 11.

A cet effet, le signal CKin est délivré sur l'entrée 81 du module 80. Celui-ci délivre les valeurs ERR et le signal EN à l'interpolateur de phase 142. On notera que l'entrée 92 de l'interpolateur de phase 142 reçoit le même signal d'horloge Clk que celui qui cadence l'accumulateur de phase 141.

Grâce à l'invention, le signal de sortie CKout présente un spectre particulièrement pur en raison du fait que les raies parasites induites par l'accumulateur de phase 141 sont fortement atténuées grâce à l'interpolateur de phase 142. Ce dernier est par exemple réalisé selon le mode de réalisation décrit ci-dessus en regard du schéma de la figure 8.

La figure 14, sur laquelle les mêmes éléments qu'à la figure 13 portent les mêmes références, illustre de façon schématique un autre exemple de synthétiseur de fréquence numérique 150. Il s'agit d'un synthétiseur indirect, appelé ainsi dans le jargon de l'Homme du métier car il comporte des moyens de rétroaction.

Le synthétiseur 150 comprend une boucle à verrouillage de phase 151 (ou PLL, de l'anglais « Phase Locked Loop »). Celle-ci comprend un comparateur de phase 145 qui reçoit le signal d'horloge Clk sur une première entrée, et dont une sortie est reliée à l'entrée de commande d'un oscillateur commandé en tension 147 (ou VCO, de l'anglais « Voltage Controlled Oscillator ») à travers un filtre passe-bas 146. La sortie de l'oscillateur 147 délivre le signal de sortie Sch du synthétiseur. Elle est reliée à une seconde entrée du comparateur de phase 145 par l'intermédiaire d'un diviseur de fréquence 148 à un rapport variable.

Le synthétiseur 150 comprend également un accumulateur de phase 141 tel que décrit ci-dessus, qui est cadencé par les fronts montants du signal d'horloge Clk.

Selon l'invention, le synthétiseur comprend également un interpolateur de phase 142 et un circuit de commande 80 associé, par exemple tels que décrits ci-dessus en regard du schéma de la figure 8. Le module 80 reçoit en entrée le signal CKin généré par l'accumulateur de phase 141 et délivre les valeurs ERR et le signal EN à l'interpolateur de phase 142. L'interpolateur de phase 142 délivre en sortie le signal CKout. On notera que l'interpolateur de phase 142 reçoit sur son entrée 92 le signal d'horloge Clk qui cadence l'accumulateur de phase 141.

Le signal CKout est appliqué sur une entrée de commande du rapport de division du diviseur de fréquence 148. Le rapport de division est par exemple égal à N pour une première valeur du signal CKout et est égal à N+1 pour une seconde valeur du signal CKout, où N est un nombre entier. Dans cette application également, l'interpolateur de phase 142 a pour fonction d'éliminer les raies parasites du signal CKin qui sont induites par l'accumulateur de phase 141 et qui autrement se retrouveraient dans le spectre du signal de sortie Sch du synthétiseur.

La figure 15, sur laquelle les mêmes éléments qu'à la figure 13 et qu'à la figure 14 portent les mêmes références, illustre de façon schématique un autre exemple de synthétiseur de fréquence numérique 160. Il s'agit également d'un synthétiseur indirect.

Le synthétiseur comprend une PLL référencée 161, qui comprend un comparateur de phase 165 dont une première entrée reçoit un signal d'entrée noté Ref. La sortie du comparateur 165 est reliée à l'entrée de commande d'un VCO référencé 167, à travers un filtre passe-bas 166. La sortie de l'oscillateur 167 délivre le signal de sortie Sch du synthétiseur.

Un diviseur de fréquence par N, où N est un nombre entier déterminé, reçoit le signal Sch en entrée et délivre le signal d'horloge Clk en sortie. Le signal Clk cadence l'accumulateur de phase 141 et est aussi délivré sur l'entrée 92 de l'interpolateur de phase 142. Le signal CKin délivré par l'accumulateur de phase 141 est reçu sur l'entrée 81 du module 80. Les sorties 82 et 83 de celui-ci délivrent respectivement les valeurs ERR et le signal EN sur les entrées respectivement 90 et 91 de l'interpolateur de phase 142.

La sortie 30 de l'interpolateur de phase délivre le signal CKout, qui est appliqué sur une seconde entrée du comparateur de phase 165.

Là encore, l'interpolateur de phase 142 permet d'éliminer les raies parasites dans le signal Sch en sortie du synthétiseur.

## Revendications

1. Circuit déphaseur variable (40) comprenant une entrée (A) pour recevoir un signal d'entrée (Sin) ayant une fréquence d'oscillation (Fin) déterminée, une sortie (B) pour délivrer un signal de sortie (Sout) ayant ladite fréquence d'oscillation (Fin) déterminée et ayant un déphasage variable ($\Delta\varphi$) par rapport audit signal d'entrée, ainsi qu'au moins une entrée de commande (C) pour recevoir un signal de commande (Is) qui commande le déphasage dudit signal de sortie par rapport audit signal d'entrée, **caractérisé en ce qu'**il comprend un oscillateur synchronisé (OS) ayant au moins une entrée de synchronisation (in1) couplée à ladite entrée du circuit déphaseur variable pour recevoir ledit signal d'entrée (Vin), au moins une sortie (out1) couplée à ladite sortie du circuit déphaseur variable pour délivrer ledit signal de sortie (Vout), ledit oscillateur synchronisé ayant une fréquence d'oscillation libre (Fo) variable qui est commandée par ledit signal de commande.

2. Circuit selon la revendication 1, **caractérisé en ce que** l'oscillateur synchronisé (OS) comprend un circuit multivibrateur astable (100) ayant une première branche (101) et une seconde branche (102) disposées en parallèle entre une borne d'alimentation positive (10) et une borne d'alimentation négative ou la masse (Gnd), des moyens délivrant dans la première branche et dans la seconde branche, un courant de repos respectif de même valeur (Io+Is) déterminée, ledit courant de repos étant commandé par le signal de commande (Is) de manière à faire varier la fréquence d'oscillation libre (Fo) de l'oscillateur synchronisé.

3. Circuit selon la revendication 2, **caractérisé en ce que**, pour chaque branche, les moyens délivrant un courant de repos dans la branche comprennent une source de courant respective (CS5,CS6) disposée en série dans la branche, qui délivre un courant de valeur déterminée (Io), et **en ce que** le signal de commande est un signal de commande en courant qui s'ajoute audit courant de valeur déterminée.

4. Interpolateur de phase (142) **caractérisé en ce qu'**il comprend :

   - une sortie de signal (30) qui délivre un signal de sortie (CKout) ;
   - au moins une entrée de données (80) pour recevoir une valeur numérique d'entrée (ERR) codée sur P bits, où P est un nombre entier, représentant l'écart entre un instant de commutation effectif d'une impulsion d'un signal à interpoler (CKin) et un instant de commutation désiré dudit signal de sortie CKout ;
   - N1 premiers circuits déphaseurs variables (1-8), selon la revendication 1 où N1 est un nombre entier strictement supérieur à l'unité, recevant chacun le signal d'entrée ayant la fréquence d'un signal de référence (Clk), les signaux d'entrée reçus par lesdites entrées respectives desdits N1 circuits déphaseurs variables étant déphasés deux à deux de 360°/N1, délivrant chacun le signal de sortie correspondant au signal reçu en entrée déphasé en fonction dudit signal de commande (Ic90+Is2) ;
   - un multiplexeur (MUX) ayant N1 entrées qui reçoivent les N1 signaux délivrés par la sortie (B) respective des N1 circuits déphaseurs variables ainsi qu'une sortie qui délivre l'un desdits N1 signaux en fonction de la valeur des Q bits de poids le plus fort (MSB) de la valeur numérique d'entrée, où Q est un nombre entier inférieur ou égal à P.

5. Interpolateur de phase selon la revendication 4, **caractérisé en ce qu'**il comprend en outre un convertisseur numérique/analogique (DAC) ayant P-Q entrées qui reçoivent les P-Q bits de poids le plus faible (LSB) de ladite valeur numérique d'entrée, et ayant une sortie qui délivre, en fonction de la valeur desdits P-Q bits, un signal analogique de correction de déphasage (Is2) qui est délivré sur l'entrée de commande (C) de l'un au moins des N1 premiers circuits déphaseurs variable.

6. Interpolateur de phase selon la revendication 4 ou la revendication 5, **caractérisé en ce que** le signal de correction de déphasage (Is2) est délivré sur l'entrée de commande (C) de chacun des N1 premiers circuits déphaseurs variables.

7. Interpolateur de phase selon la revendication 4 ou la revendication 5, **caractérisé en ce qu'**il comprend en outre un démultiplexeur (DEMUX) ayant une entrée qui reçoit le signal de correction de déphasage (Is2), au moins N1 sorties qui sont respectivement couplées à l'entrée de commande (B) des N1 premiers circuits déphaseurs variables (1-8), pour orienter ledit signal de correction de déphasage vers l'entrée de commande (B) de l'un desdits N1 premiers circuits déphaseurs variables en fonction de la valeur des Q bits de poids le plus fort (MSB) de la valeur numérique d'entrée.

8. Interpolateur de phase selon l'une quelconque des revendications 4 à 7, **caractérisé en ce qu'**il comprend en outre un générateur d'horloge multiphase (100) comprenant :

   - N1 seconds circuits déphaseurs variables (9-16) identiques aux N1 premiers circuits déphaseurs variables (1-8), et reliés en série via leurs entrées (A) et sorties (B) respectives, l'entrée d'un premier (9) desdits N1 seconds circuits déphaseurs variables recevant le signal de référence (Clk) ;
   - un comparateur de phase (PC1) ayant une première entrée qui reçoit le signal de référence (Clk), une seconde entrée qui est reliée à la sortie d'un dernier (16) desdits N1 seconds circuits déphaseurs variables, ainsi qu'une sortie;
   - un filtre passe-bas (LP1) ayant une entrée couplée à la sortie dudit comparateur de phase, et une sortie ;
   - un module d'adaptation (TC1) ayant une entrée couplée à la sortie dudit filtre passe-bas et au moins N1 premières sorties délivrant respectivement N1 premiers signaux de calibration (Ic45) identiques, qui sont appliqués sur les entrées de commande (C) respectives desdits N1 seconds circuits déphaseurs variables.

9. Interpolateur de phase selon la revendication 8, **caractérisé en ce que** le module d'adaptation (TC1) du générateur d'horloge multiphase (100) comprend une N1 + 1-ième sortie, délivrant un N1 + 1-ième signal de calibration (lc45) identique aux signaux calibration générés par lesdits N1 premières sorties, et couplée au convertisseur numérique-analogique (DAC) afin de lui fournir une première valeur de référence.

10. Interpolateur de phase selon l'une quelconque des revendications 4 à 9, **caractérisé en ce qu'**il comprend en outre des moyens de calibration (200) comprenant :

    - N2 troisièmes circuits déphaseurs variables (17-20) identiques aux N1 premiers circuits déphaseurs variables (1-8), et reliés en série via leurs entrées (A) et sorties (B) respectives, l'entrée d'un premier (17) desdits N2 troisièmes circuits déphaseurs variables recevant le signal de référence (Clk);
    - un comparateur de phase (PC2) ayant une première entrée qui reçoit le signal de référence (Clk), une seconde entrée qui est reliée à la sortie d'un dernier (20) desdits N2 troisièmes circuits déphaseurs variables, ainsi qu'une sortie ;
    - un filtre passe-bas (LP2) ayant une entrée couplée à la sortie dudit comparateur de phase, et une sortie ;
    - un module d'adaptation (TC2) ayant une entrée couplée à la sortie dudit filtre passe-bas et au moins N2 + 1 sorties délivrant respectivement N2 + 1 seconds signaux de calibration (Ic90) identiques, parmi lesquelles N2 sorties sont couplées aux entrées de commande (C) respectives desdits N2 troisièmes circuits déphaseurs variables pour délivrer l'un respectif parmi N2 desdits second signaux de calibration.

11. Interpolateur de phase selon la revendication 10, **caractérisé en ce que** le module d'adaptation (TC2) des moyens de calibration (200) comprend N2 + 1 sorties délivrant respectivement N2 + 1 seconds signaux de calibration (lc90) identiques, parmi lesquelles, en outre, la N2 + 1-ième sortie est couplée au convertisseur numérique/analogique (DAC) afin de lui fournir une seconde valeur de référence.

12. Interpolateur de phase selon la revendication 10, **caractérisé en ce que** le module d'adaptation (TC2) des moyens de calibration (200) comprend N2 + 2xN1 sorties délivrant respectivement N2 + 2xN1 seconds signaux de calibration (lc90) identiques, parmi lesquelles, en outre N1 autres sorties sont couplées aux entrées de commande (C) respectives des N1 deuxièmes circuits déphaseurs variables (9-16) du générateur d'horloge multiphase (100) pour délivrer l'un respectif parmi N1 autres desdits second signaux de calibration, et parmi lesquelles N1 autres sorties sont couplées aux entrées de commande (C) respectives des N1 premiers circuits déphaseurs variables (1-8) pour délivrer l'un respectif parmi N1 autres desdits second signaux de calibration.

13. Interpolateur de phase selon l'une quelconque des revendications 4 à 12, **caractérisé en ce qu'**il comprend en outre une entrée (91) pour recevoir un signal (EN) d'activation/désactivation du multiplexeur (MUX), permettant de commander la fréquence du signal de sortie (CKout) par rapport à la fréquence du signal de référence (Clk).

14. Synthétiseur de fréquence numérique (140,150,160) **caractérisé en ce qu'**il comprend un accumulateur de phase (141) couplé à un interpolateur de phase (142) selon l'une quelconque des revendications 4 à 13.

**Patentansprüche**

1.  Variable Phasenschieberschaltung (40), umfassend
    einen Eingang (A) zum Empfangen eines Eingangssignals (Sin), das eine bestimmte Oszillationsfrequenz (Fin) aufweist,
    einen Ausgang (B) zum Ausliefern eines Ausgangssignals (Sout), welches die bestimmte Oszillationsfrequenz (Fin) aufweist und eine bezüglich des Eingangssignals variable Phasenverschiebung ($\Delta\varphi$) aufweist, sowie wenigstens einen Steuer-/Regeleingang (C) zum Empfangen eines Steuersignals (Is), welches die Phasenverschiebung des Ausgangssignals bezüglich des Eingangssignals steuert/regelt,
    **dadurch gekennzeichnet, dass**
    sie einen synchronisierten Oszillator (OS) umfasst, der wenigstens einen mit dem Eingang der variablen Phasenschieberschaltung verbundenen Synchronisationseingang (in1) zum Empfangen des Eingangssignals (Vin), wenigstens einen mit dem Ausgang der variablen Phasenschieberschaltung verbundenen Ausgang (out1) zum Ausliefern des Ausgangssignals (Vout) aufweist, wobei der synchronisierte Oszillator eine variable, freie Oszillationsfrequenz (Fo) aufweist, welche durch das Steuersignal gesteuert/geregelt ist.

2.  Schaltung nach Anspruch 1, **dadurch gekennzeichnet, dass** der synchronisierte Oszillator (OS) umfasst:

    eine astabile Multivibratorschaltung (100), welche einen ersten Zweig (101) und einen zweiten Zweig (102) aufweist, die parallel zwischen einer positiven Versorgungsklemme (10) und einer negativen Versorgungsklemme oder Masse (Gnd) angeordnet sind,
    Mittel, welche im ersten Zweig und im zweiten Zweig einen jeweiligen Ruhestrom vom gleichen bestimmten Wert (Io+Is) liefern, wobei der Ruhestrom durch das Steuersignal (Is) derart gesteuert/geregelt ist, dass die freie Oszillationsfrequenz (Fo) des synchronisierten Oszillators variiert wird.

3.  Schaltung nach Anspruch 2, **dadurch gekennzeichnet, dass** die einen Ruhestrom im Zweig liefernden Mittel für jeden Zweig eine jeweilige in Serie zum Zweig angeordnete Stromquelle (CS5, CS6) umfassen, die einen Strom mit bestimmtem Wert (Io) liefert, und dass das Steuersignal ein Stromsteuersignal ist, das dem Strom mit bestimmtem Wert hinzugefügt wird.

4.  Phaseninterpolator (142), **dadurch gekennzeichnet, dass** er umfasst:

    - einen Signalausgang (30), der ein Ausgangssignal (CKout) liefert;
    - wenigstens einen Dateneingang (80) zum Empfangen eines digitalen, auf P Bits codierten Eingangswerts (ERR), wobei P eine ganze Zahl ist, der einen Abstand zwischen einem Zeitpunkt effektiver Kommutation eines Impulses eines zu interpolierenden Signals (Ckin) und einem Zeitpunkt gewünschter Kommutation des Ausgangssignals CKout repräsentiert;
    - N1 erste variable Phasenschieberschaltungen (1-8) gemäß Anspruch 1, wobei N1 eine ganze Zahl ist, die ausschließlich grösser ist als die Einheit, von denen jede das Einganssignal mit der Frequenz eines Referenzsignals (Clk) empfängt, wobei die durch die jeweiligen Eingänge der N1 variablen Phasenschieberschaltungen empfangenen Eingangssignale paarweise phasenverschoben um 360°/N1 sind, und von denen jede das Ausgangssignal liefert, das dem in Funktion des Steuersignals (Ic90+Is2) phasenverschobenen, am Eingang emp-fangenen Signal entspricht;
    - einen Multiplexer (MUX) mit N1 Eingängen, welche die vom jeweiligen Ausgang (B) der N1 variablen Phasenschieberschaltungen gelieferten N1 Signale empfangen, sowie mit einem Ausgang, der eines der N1 Signale in Funktion des Werts von Q Bits mit dem stärksten Gewicht (MSB) des digitalen Eingangswerts liefert, wobei Q einen ganze Zahl kleiner oder gleich P ist.

5.  Phaseninterpolator nach Anspruch 4, **dadurch gekennzeichnet, dass** er ferner einen Digital-/Analogwandler (DAC) umfasst, der P-Q Eingänge aufweist, welche die P-Q Bits mit dem geringsten Gewicht (LSB) des digitalen Eingangswerts empfangen, und der einen Ausgang aufweist, welcher in Funktion der P-Q Bits ein analoges Phasenverschie-bungssignal (Is2) liefert, das zum Steuer-/Regeleingang (C) wenigstens einer der N1 ersten variablen Phasenschieberschaltungen geliefert wird.

6.  Phaseninterpolator nach Anspruch 4 oder Anspruch 5, **dadurch gekennzeichnet, dass** das Phasenverschiebungskorrektursignal (ls2) zum Steuer-/Regeleingang (C) jeder der N1 ersten variablen Phasenschieberschaltungen geliefert wird.

7. Phaseninterpolator nach Anspruch 4 oder Anspruch 5, **dadurch gekennzeichnet, dass** er ferner umfasst: einen Demultiplexer (DEMUX), der einen das Phasenverschiebungskorrektursignal (ls2) empfangenden Eingang aufweist, wenigstens N1 Augänge die jeweils mit Steuereingängen (B) der N1 ersten variablen Phasenschieberschaltungen (1-8) verbunden sind, um das Phasenverschiebungskorrektursignal zum Steuer-/Regeleingang (B) von einer der N1 variablen Phasenschieberschaltungen in Funktion des Werts der Q Bits mit größtem Gewicht (MSB) des digitalen Eingangswerts zu richten.

8. Phaseninterpolator nach einem der Ansprüche 4 bis 7, **dadurch gekennzeichnet, dass** er ferner einen Multiphasen Taktgeber (100) aufweist, umfassend:

    - N1 zweite variable Phasenschieberschaltungen (9-16), welche identisch mit den ersten variablen Phasenschieberschaltungen (1-8) sind, und welche in Serie über ihre jeweiligen Eingänge (A) und Ausgänge (B) verbunden sind, wobei der Eingang eines ersten (9) der N1 zweiten variablen Phasenschieberschaltungen das Referenzsignal (Clk) empfängt;
    - einen Phasenkomparator (PC1), der einen ersten, das Referenzsignal (Clk) empfangenden Eingang, einen mit dem Ausgang eines letzten (16) der N1 zweiten variablen Phasenschieberschaltungen verbundenen Eingang sowie einen Ausgang aufweist;
    - einen Tiefpassfilter (LP1), der einen mit dem Ausgang des Phasenkomparators verbundenen Eingang und einen Ausgang aufweist;
    - ein Adaptionsmodul (TC1) mit einem mit dem Ausgang des Tiefpassfilters verbundenen Eingang und mit wenigstens N1 ersten Ausgängen, welche jeweils N1 erste identische Kalibrierungssignale (1c45) liefern, welche an den jeweiligen Steuereingängen (C) der N1 zweiten variablen Phasenschieberschaltungen angewendet werden.

9. Phaseninterpolator nach Anspruch 8, **dadurch gekennzeichnet, dass** das Adaptionsmodul (TC1) des Multiphasen Taktgebers (100) einen N1+1-ten Ausgang umfasst, der ein N1+1-tes Kalibrierungssignal (Ic45), das identisch ist mit den durch die N1 ersten Ausgänge erzeugten Kalibrierungssignalen, liefert, und der mit dem Digital-/Analogwandler (DAC) verbunden ist, um diesem einen ersten Referenzwert zu liefern.

10. Phaseninterpolator nach einem der Ansprüche 4 bis 9, **dadurch gekennzeichnet, dass** er ferner Kalibrierungsmittel (200) aufweist, umfassend:

    - N2 dritte variable Phasenschieberschaltungen (17-20), welche identisch mit den ersten variablen Phasenschieberschaltungen (1-8) sind, und welche in Serie über ihre jeweiligen Eingänge (A) und Ausgänge (B) verbunden sind, wobei der Eingang eines ersten (17) der N2 dritten variablen Phasenschieberschaltungen das Referenzsignal (Clk) empfängt;
    - einen Phasenkomparator (PC2), der einen ersten, das Referenzsignal (Clk) empfangenden Eingang, einen mit dem Ausgang eines letzten (20) der N2 dritten variablen Phasenschieberschaltungen verbundenen Eingang sowie einen Ausgang aufweist;
    - einen Tiefpassfilter (LP2), der einen mit dem Ausgang des Phasenkomparators verbundenen Eingang und einen Ausgang aufweist;
    - ein Adaptionsmodul (TC2) mit einem mit dem Ausgang des Tiefpassfilters verbundenen Eingang und wenigstens N2+1 Ausgängen, welche jeweils N2+1 identische zweite Kalibrierungssignale (Ic90) liefern, wobei von den Ausgängen N2 Ausgänge mit jeweiligen Steuer-/Regeleingängen (C) der N2 dritten variablen Phasenschieberschaltungen verbunden sind, um das jeweilige Kalibrierungssignal unter den N2 zweiten Kalibrierungssignalen zu liefern.

11. Phaseninterpolator nach Anspruch 10, **dadurch gekennzeichnet, dass** das Adaptionsmodul (TC2) der Kalibrierungsmittel (200) N2+1 Ausgänge umfasst, welche jeweils N2+1 zweite identische Katibrierungssignale (Ic90) liefern, unter denen ferner der N2+1-te Ausgang mit dem Digital-/ Analogwandler (DAC) verbunden ist, um diesem einen zweiten Referenzwert zu liefern.

12. Phaseninterpolator nach Anspruch 10, **dadurch gekennzeichnet, dass** das Adaptionsmodul (TC2) der Kalibrierungsmittel (200) N2+2xN1 Ausgänge umfasst, welche jeweils N2+2xN1 identische zweite Kalibrierungssignale (Ic90) liefern, unter denen ferner N1 andere Ausgänge mit den jeweiligen. Steuer-/Regeleingängen (C) der N1 zweiten variablen Phasenschieberschaltungen (9-16) des Multiphasen Taktgebers (100) verbunden sind, um das jeweilige Kalibrierungssignal unter den N1 anderen zweiten Kalibrierungssignalen zu liefern, und unter denen N1 andere Ausgänge mit jeweiligen Steuereingängen (C) der N1 ersten variablen Phasenschieberschaltungen (1-8) verbunden sind, um das jeweilige Kalibrierungssignal unter den N1 anderen zweiten Kalibrierungssignalen zu liefern.

13. Phaseninterpolator nach einem der Ansprüche 4 bis 12, **dadurch gekennzeichnet, dass** er ferner einen Eingang (91) umfasst, um ein Aktivierungs-/Deaktivierungs-Signal (EN) des Multiplexers (MUX) zu empfangen, was es erlaubt, die Frequenz des Ausgangssignals (CKout) bezüglich der Referenzsignalfrequenz (Clk) zu steuern/regeln.

14. Digitaler Frequenzgenerator (140, 150, 160), **dadurch gekennzeichnet**, das er einen Phasenspeicher (141) aufweist, der mit einem Phaseninterpolator (142) gemäß einem der Ansprüche 4 bis 13 verbunden ist.

**Claims**

1. Variable phase-shifting circuit (40) comprising an input (A) for receiving an input signal (Sin) having a specified oscillation frequency (Fin), an output (B) for delivering an output signal (Sout) having the said specified oscillation frequency (Fin) and having a variable phase shift ($\Delta\varphi$) with respect to the said input signal, and at least one control input (C) for receiving a control signal (Is) which controls the phase-shift of the said output signal with respect to the said input signal, **characterized in that** it includes a synchronized oscillator (OS) having at least a synchronization input (in1) coupled to the said input of the variable phase-shifting circuit for receiving the said input signal (Vin), at least an output (out1) coupled to the said output of the variable phase-shifting circuit for delivering the said output signal (Vout), the said synchronized oscillator having a variable free-running oscillation frequency (Fo) controlled by the said control signal.

2. Circuit according to Claim 1, **characterized in that** the synchronized oscillator (OS) includes an astable multivibrator circuit (100) having a first branch (101) and a second branch (102) arranged in parallel between a positive supply terminal (10) and a negative supply terminal or ground (Gnd), means delivering into the first branch and into the second branch, a respective quiescent current of the same specified value (Io+Is), the said quiescent current being controlled by the control signal (Is) so as to vary the free-running oscillation frequency (Fo) of the synchronized oscillator.

3. Circuit according to Claim 2, **characterized in that**, for each branch, the means delivering a quiescent current into the branch include a respective current source (CS5, CS6) arranged in series in the branch, which delivers a current of a specified value (Io), and **in that** the control signal is a current control signal that is added to the said current of a specified value.

4. Phase interpolator (142) **characterized in that** it includes:

   - a signal output (30) that delivers an output signal (CKout);
   - at least one data input (80) for receiving a digital input value (ERR) coded in P bits, where P is an integer, representing the difference between an actual instant of switching of a pulse of a signal to be interpolated (CKin) and a desired instant of switching the said output signal (CKout);
   - N1 first variable phase-shifting circuits (1-8) according to claim 1, where N1 is an integer strictly greater than one, each receiving the input signal having the frequency of a reference signal (Clk), the input signals received by the said respective inputs of the said N1 variable phase-shifting circuits being respectively phase-shifted by 360°/N1, each delivering the output signal corresponding to the signal received at the input phase-shifted based on said control signal (Ic90+Is2);
   - a signal output (30) that delivers an output signal (CKout);
   - a multiplexer (MUX) having N1 inputs that receive the N1 signals delivered by the respective output (B) of the N1 variable phase-shifting circuits and an output that delivers one of the said N1 signals based on the value of the Q most significant bits (MSB) of the digital input value, where Q is an integer less than or equal to P.

5. Phase interpolator according to Claim 4, **characterized in that** it further includes a digital/analog converter (DAC) having P-Q inputs that receive the P-Q least significant bits (LSB) of the said digital input value, and having an output that delivers, based on the value of the said P-Q bits, an analog phase-shift correction signal (Is2) which is delivered at the control input (C) of at least one of the N1 first variable phase-shifting circuits.

**6.** Phase interpolator according to Claim 4 or Claim 5, **characterized in that** the phase-shift correction signal (ls2) is delivered at the control input (C) of each of the N1 first variable phase-shifting circuits.

**7.** Phase interpolator according to Claim 4 or Claim 5, **characterized in that** it further includes a demultiplexer (DEMUX) having an input receiving the phase-shift correction signal (ls2), at least N1 outputs respectively coupled to the control input (B) of the N1 first variable phase-shifting circuits (1-8), for directing the said phase-shift correction signal to the control input (B) of one of the said N1 first variable phase-shifting circuits based on the value of the Q most significant bits (MSB) of the digital input value.

**8.** Phase interpolator according to any of Claims 4 to 7, **characterized in that** it further includes a multiphase clock generator (100) comprising:

- N1 second variable phase-shifting circuits (9-16) identical to the N1 first variable phase-shifting circuits (1-8), connected in series via their respective inputs (A) and outputs (B), the input of a first (9) of the said N1 second variable phase-shifting circuits receiving the reference signal (Clk);
- a phase comparator (PC1) having a first input that receives the reference signal (Clk), a second input which is connected to the output of a last (16) of the said N1 second variable phase-shifting circuits, and an output;
- a low-pass filter (LP1) with an input coupled to the output of the said phase comparator, and an output;
- an adaptation module (TC1) having an input coupled to the output of the said low-pass filter and at least N1 first outputs delivering N1 identical first calibration signals (lc45) respectively, which are applied to the respective control inputs (C) of the said N1 second variable phase-shifting circuits.

**9.** Phase interpolator according to Claim 8, **characterized in that** the adaptation module (TC1) of the multiphase clock generator (100) includes an N1 + 1-th output, delivering an N1 + 1-th calibration signal (Ic45) identical to the calibration signals generated by the said N1 first outputs, and coupled to the digital-analog converter (DAC) in order to provide it with a first reference value.

**10.** Phase interpolator according to any of Claims 4 to 9, **characterized in that** it further includes calibration means (200) comprising:

- N2 third variable phase-shifting circuits (17-20) identical to the N1 first variable phase-shifting circuits (1-8), connected in series via their respective inputs (A) and outputs (B), the input of a first (17) of the said N2 third variable phase-shifting circuits receiving the reference signal (Clk);
- a phase comparator (PC2) having a first input that receives the reference signal (Clk), a second input which is connected to the output of a last (20) of the said N2 third variable phase-shifting circuits, and an output;
- a low-pass filter (LP2) having an input coupled to the output of the said phase comparator, and an output;
- an adaptation module (TC2) having an input coupled to the output of the said low-pass filter and at least N2 + 1 outputs delivering N2 + 1 identical second calibration signals (lc90) respectively, among which N2 outputs are coupled to the respective control inputs (C) of the said N2 third variable phase-shifting circuits for delivering the respective one from N2 of the said second calibration signals.

**11.** Phase interpolator according to Claim 10, **characterized in that** the adaptation module (TC2) of the calibration means (200) includes N2 + 1 outputs delivering respectively N2 + 1 identical second calibration signals (lc90) among which, in addition, the N2 + 1-th output is coupled to the digital-analog converter (DAC) so as to provide it with a second reference value.

**12.** Phase interpolator according to Claim 10, **characterized in that** the adaptation module (TC2) of the calibration means (200) includes N2 + 2xN1 outputs delivering respectively N2 + 2xN1 identical second calibration signals (lc90), among which, N1 other outputs are further coupled to the respective control inputs (C) of the N1 second variable phase-shifting circuits (9-16) of the multiphase clock generator (100) for delivering the respective one among N1 others of the said second calibration signals, and among which N1 other outputs are coupled to the respective control inputs (C) of the N1 first variable phase-shifting circuits (1-8) for delivering the respective one among N1 others of the said second calibration signals.

**13.** Phase interpolator according to any of Claims 4 to 12, **characterized in that** it further includes an input (91) for receiving a signal (EN) for activating/deactivating the multiplexer (MUX), to control the frequency of the output signal (CKout) with respect to the reference signal frequency (Clk).

**14.** Digital frequency synthesizer (140, 150, 160) **characterized in that** its includes a phase accumulator (141) coupled to a phase interpolator (142) according to any of Claims 4 to 13.

**FIG. 1**

**FIG. 2**

**FIG. 3**

## FIG. 4

## FIG. 5

**FIG. 6**

**FIG. 10**

FIG. 8

FIG. 9

**FIG. 7**

**FIG. 11**

**FIG. 12**

**FIG. 13**

**FIG. 14**

**FIG. 15**